Europäisches Patentamt

European Patent Office

Office européen des brevets

(19)

(11) Publication number: **0 181 193**
**B1**

# EUROPEAN PATENT SPECIFICATION

(12)

(45) Date of publication of the patent specification:
**12.09.90**

(51) Int. Cl.⁵: **H01J 35/00, G03F 7/20**

(21) Application number: 85308028.1

(22) Date of filing: 05.11.85

(54) X-ray irradiation system.

(30) Priority: 08.11.84 US 669440

(43) Date of publication of application:
**14.05.86 Bulletin 86/20**

(45) Publication of the grant of the patent:
**12.09.90 Bulletin 90/37**

(84) Designated Contracting States:
**AT BE CH DE FR GB IT LI LU NL SE**

(56) References cited:
**EP-A- 0 058 137**
**US-A- 3 743 842**
**US-A- 4 184 078**
**US-A- 4 344 013**

JOURNAL OF APPLIED PHYSICS, vol. 47, no. 6,
June 1976, pages 2402-2414, American Institute of
Physics, New York, US; K. EIDMANN et al.: "X-ray
emission from laser-irradiated plane solid targets"
SOVIET JOURNAL OF QUANTUM ELECTRONICS, vol. 9,
no. 2, February 1979, pages 251-254, American Institute
of Physics, New York, US; Yu.A. BYKOVSKII et al.:
"Characteristics of soft x-ray emission from a plasma
formed by moderate-intensity laser irradiation of a
target" 000
APPLIED OPTICS, vol. 23, no. 9, 1st May 1984,

(73) Proprietor: **HAMPSHIRE INSTRUMENTS, INC, 10,
Carlson Road, Monroe New York(US)**

(72) Inventor: **Forsyth, James Morton, 54 Old Forge Lane,
Pittsford New York 14534(US)**

(74) Representative: **Miller, Joseph et al, J. MILLER & CO.
Lincoln House 296-302 High Holborn, London
WC1V 7JH(GB)**

(56) References cited: (continuation)
pages 1428-1433, New York, US; D.J. NAGEL et al.:
"Repetitively pulsed-plasma soft x-ray source"

## Description

This invention relates to X-ray irradiation systems comprising an excitation beam whose path is directed towards a target, and whose power is such as to create an X-ray emitting plasma upon striking the target. The invention has particular application to such a system in which plasma emits soft X-rays for use in a commercial X-ray lithography system.

According to the invention, an X-ray irradiation system comprising an excitation beam whose path is directed towards a target and whose power is sufficient to cause an X-ray emitting plasma to be created upon striking the target, and means to position an object to be irradiated within the region of emitted X-rays is characterised in that the target has a cavity therein, the target being so positioned that the path of the beam intersects the cavity, the plasma being created at least partially therein, and the object to be irradiated being positioned within a region defined by a cone of a certain angle to the path, the cone being such that the intensity of the X-rays within the region is greater than the intensity of the X-rays if the path of the beam intersected a non-cavity part of the target.

An embodiment of the invention may be an X-ray lithography system comprising a high repetition rate, high power laser pulse generator, a target towards which the laser pulse is directed, the target being of material in which a soft X-ray emitting plasma is created each time a laser pulse is directed towards the target, the target having a cavity therein formed by at least one prior laser pulse having been directed towards the target and positioned so that at least one subsequent laser pulse is directed into the cavity to create at least a portion of the plasma in the cavity, whereby a region of higher intensity X-ray results, and semiconductor wafer holding and moving means for positioning selected areas of a semiconductor wafer in an exposing area, the exposing area being within the higher intensity X-ray region.

The scope of the invention is defined by the appended claims, and how it can be carried into effect is hereinafter particularly described with reference to the accompanying drawings, in which:-

Figure 1 shows diagrammatically an X-ray irradiation system according to the invention,

Figures 2A, 2B, 2C and 2D show the formation of a cavity in the target after several applications of a laser pulse to the target of Figure 1,

Figure 3 shows diagrammatically an X-ray lithography system incorporating the invention, and

Figure 4 shows diagrammatically another X-ray lithography system according to the invention.

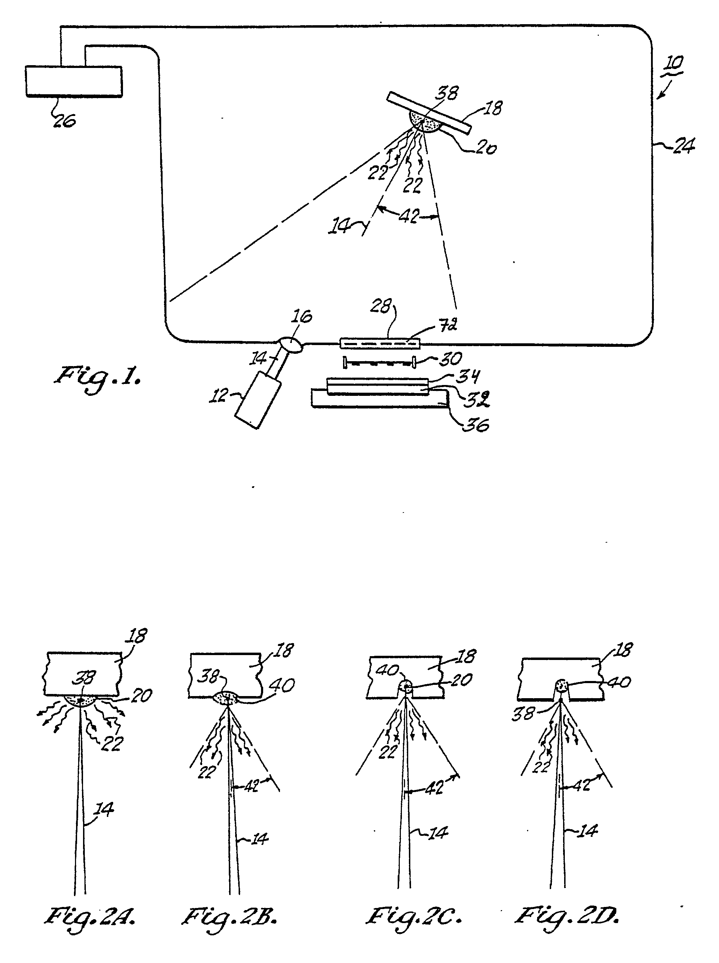

An X-ray lithography system 10 (Figure 1) includes a laser generator 12 which generates a high powered pulse laser beam 14 focussed by a lens 16 onto a target 18, which may be of a material such as aluminium or stainless steel. The power contained in the laser beam pulse focussed on the target 18 should be sufficient to cause a plasma to be created on the target 18. The plasma in turn will generate soft X-rays in the range of 0.2 to 2nm depending upon the material of target 18.

The target 18 must be in an evacuated chamber 24 which may be maintained at a pressure of 1.333224 Pa (0.01 Torr) by a vacuum pump 26. The lens 16 may be positioned in the outer wall of the chamber 24. An X-ray transparent window 28 is also provided in the bottom of the chamber 24 to allow the X-rays 22 to travel from the interior of chamber 24 to the exterior thereof. The window 28 may be of a suitable solid material, such as beryllium, which is transparent to X-rays or it may be an opening closed by an aerodynamic jet stream of gas such as described in co-pending patent application No. 85307889.7 (EP-A 0 174 877).

External to the chamber 24 is an X-ray mask 30 to provide an image of X-rays to a semiconductor wafer 32 covered by X-ray resist material 34. Wafer handler means 36 is provided to move the wafer to various positions so that different areas may be exposed to the pattern of X-rays defined by the mask 30. Suitable wafer handling equipment is shown in U.S-A-4,444,492.

The system 10, as thus far described, is typical of the prior art of US-A-3,743,842 and US-A-4,184,078, and operates by a single pulse from laser 12 along the beam 14 being provided and focussed by lens 16 at a spot 38 of target 18. The focussed laser pulse creates a plasma 20 which emits X-rays 22. The X-rays travel throughout chamber 24 and in particular through window 28 and mask 30 to cause a pattern to be exposed on photoresist 34. In the prior art, the target 18 is either manually moved or replaced after each laser pulse is applied thereto and the same procedure repeated. Due to the long length of time required to manually move or replace target 18, the practicalities of using the prior art versions of system 10 are quite limited. Conventional lithography equipment, such as the photolithography systems described in US-A-4,444,492, include wafer handling means 36 which allow exposures to occur approximately every two seconds. Advantage cannot be taken of this, because of the long time required to manually move or replace target 18.

The teachings of the prior art also suggest that it is improper to provide more than one pulse from laser 12 towards the same spot 38 on target 18. Each time a pulse is applied and a plasma created, a certain amount of material of target 18 is burnt away due to the tremendous heat of the plasma. This results in a cavity being formed on the surface of target 18 at spot 38 where laser beam 14 strikes target 18. In the past when experimenters have tried to direct a second laser beam into the cavity so formed, a much lower intensity of X-rays resulted. In these experiments, the detector for X-ray intensity was placed at an angle equal to or greater than 45 degrees away from the path of beam 14. (See, for example, D. J. Nagel et al.: "Repetitively pulsed-plasma soft x-ray source", Applied Optics, Vol. 23, No. 9, 1 May 1984).

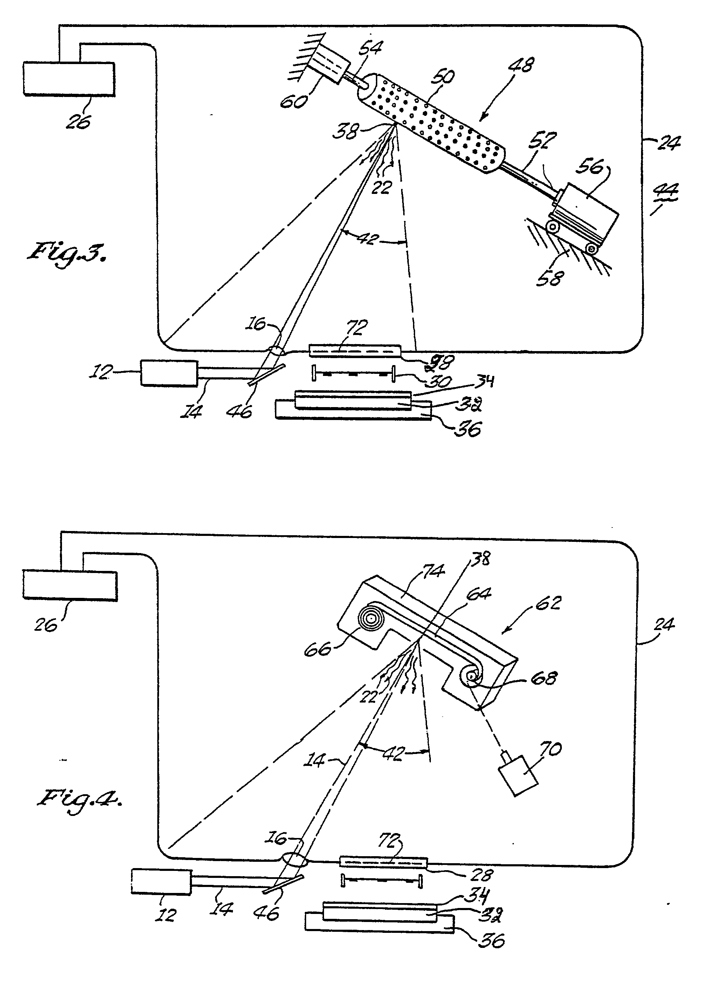

In explanation of what occurs when a series of laser beam pulses is applied to target 18, the laser beam 14 (Figure 2A) strikes target 18 at spot 38 causing a plasma 20 to be created essentially on the outer surface of target 18, and X-rays 22 to be emitted from the plasma 20. The X-rays 22 are provided with an approximately uniform intensity throughout the entire area below target 18. After the plasma 20 has dissipated, a cavity 40 (Figure 2B) is formed. As additional laser pulses are applied against target 18 and focussed on spot 38, cavity 40 increases in depth, plasma 20 is created within the cavity 40 until, as shown in Figures 2C and 2D, plasma 20 is who within cavity 40. Laser pulses could continue to be focussed on point 38 and cavity 40 would become deeper as shown in Figure 2D.

As cavity 40 increases in depth and plasma 20 is formed within the cavity, the temperature of plasma 20 increases due to the more confined area in which it is formed. This causes a greater intensity of X-rays to be emitted. In addition, these X-rays are confined to a certain cone surrounding laser beam 14 and represented by the conical angle 42 (Figures 2B, 2C and 2D). Thus, the intensity of the X-rays within the cone defined by angle 42 is significantly greater than the intensity of the X-rays beyond the cone defined by angle 42, which is signficantly less than the intensity of the X-rays originally emitted (Figure 2A). This phenomenon of a significantly higher intensity of X-rays within the cone defined by angle 42 escaped detection in the prior art experimentations because of the positioning of the X-ray detector outside the cone defined by angle 42.

As the depth of cavity 40 increases, the angle of the cone defined by angle 42 decreases. X-rays are absorbed into the side of the cavity wall, thereby creating additional heat. The higher plasma density caused by the confinement of the cavity walls causes the plasma in the cavity to act more as an ideal radiator, thereby increasing the intensity of the X-rays.

Experiments have shown that cavities which produce significant increases in X-ray output will be deep enough below the spot 38 to cause angle 42 to be approximately 45 degrees. If the cavity is preformed by a focussed laser pulse, successive laser pulses focussed into the cavity will cause the cavity to become deeper, reducing the available cone angle 42. The intensity of the X-rays within the cone defined by angle 42 may be two or more times greater than the intensity of the X-rays emitted from plasma on the surface (Figure 2A). Repeated irradiation of the cavity by many laser pulses eventually causes the X-ray emission within the cone angle 42 to decline. This occurs because the outer walls of the cavity serve as a heat sink for the hot plasma created at the bottom of the cavity. This colder material acts to absorb some of the X-ray radiation under these conditions. Empirically, a range of cavity depths produced by one or more focussed laser pulses of from 0.3 to 0.8 mm is found to produce significantly enhanced X-ray emission within cone angle 42.

In order to take advantage of the phenomenon of the higher intensity X-rays within the cone defined by angle 42, laser 12 (Figure 1) and lens 16 are positioned so that the window 28, mask 30 and the portion of semiconductor wafer 32 being exposed are all positioned within the critical angle 42 of the cone of high intensity X-rays. This requires that lens 16 be placed in close proximity to window 28. This may require the use of directing mirrors so that laser 12 does not interfere with the wafer handling device 36 as it moves wafer 34 between the various positions to be exposed.

By placing mask 30 and the area of wafer 32 which is to be exposed within the cone defined by angle 42, significant advantages are achieved. First a lower powered laser 12 may be used to generate the necessary intensity of X-rays to expose the X-ray resist 34. Further, with a higher intensity of X-rays, different types of X-ray resist material may be used. Further, the ability to direct a plurality of laser pulses at the same spot allows multiple exposures to be obtained without having to move or replace target 18.

In a second embodiment of the invention (Figure 3), a different configuration target is shown which can be mechanically moved so that a large quantity of X-ray exposures can be easily and automatically obtained without having to physically change the target. The X-ray lithography system 44 includes a mirror 46 for directing the laser beam 14 from laser 12 through lens 16. The target 18 of Figure 1 is replaced by a target system 48. Target system 48 includes a cylindrical drum 50 constructed of an appropriate material useful as a target. Such material may be aluminium or stainless steel, as previously mentioned. Attached to the ends of cylinder 50 are a shaft 52 and a threaded rod 54. A motor 56 is attached to shaft 52 to rotate the shaft 52, and drum 50. The motor 56 rides on a rail 58 aligned with the common axis of drum 50, shaft 52 and rod 54. Threaded rod 54, which is attached to the other end of cylinder 50, is engaged in a stationary threaded nut 60. As motor 56 rotates shaft 52, drum 50 and rod 54, the engagement of the nut 60 and rod 54 causes endwise movement of the entire target system 48. During this movement, motor 56 rides along rails 58.

In operation, cylindrical drum 50 is positioned so that laser beam 14 is focussed initially on a spot close to one end thereof. After an appropriate number of laser pulses have been applied to a particular spot on drum 50, drum 50 is rotated a small amount. This allows a new series of pulses to be applied to a point just adjacent to the prior spot to which the laser pulses were previously applied. As drum 50 continues to be rotated a small amount each time, a helical path of target spots is formed. The amount by which drum 50 is rotated is determined by the diameter of the cavity 40 (Figures 2B, 2C, and 2D). As cavity 40 is of a very small size, 0.5 mm or less, the number of cavities permitted per rotation of drum 50 is great. Of course the size of drum 50 will determine the actual number of available spots to create cavities. Further the lateral movement per rotation will be quite small. The actual size of drum 50 can be selected so that a large number of target positions can be obtained. This will allow the target to be used for a long period of time before replacement is necessary.

In another embodiment of the invention (Figure 4) an alternative target system 62 replaces the target system 48. Target system 62 includes an elongated target strip 64, which initially is almost wholly wound around a feed reel 66, having a run across the target area to a take-up reel 68. Take-up reel 68 is driven by a motor 70 to cause strip 66 to move in short increments past spot 38 at which laser beam 14 is focussed. Target system 62 may be fabricated into a cassette 74 for easy removal and replacement. Lateral movement of the cassette 74 transverse to the length of the strip 66 may also be provided to increase the number of target spots available. Alternatively, means associated with the mirror 46 could move the mirror by incremental amounts to direct the laser beam pulses at selected locations perpendicular to the path of movement of strip 64.

In using either the long life target system 48 (Figure 3) or the target system 62 (Figure 4), it is necessary to provide the initial cavity 40 on the target. This may be accomplished by providing an initial laser pulse to either drum 50 or strip 64 while blocking the X-rays provided through window 28 from reaching mask 30. Such blockage may be accomplished by providing a shutter 72 within window 28. Shutter 72 may be an X-ray absorbing material strobed across window 40 in conjunction with the formation of cavity 40. In the alternative, a higher energy laser beam pulse could be provided initially to cause a greater intensity of X-rays throughout the entire area of chamber 24. Thereafter, lower energy laser pulses would be provided. By controlling the energy within each of the laser pulses provided against the target drum 50 or strip 64, the intensity of the X-rays passing through window 28 can be controlled. Further, an initialization procedure could be used to create all the initial cavities before the chip handling means 36 moves the chip 32 into position. If such a procedure were utilized, means would be required to initialize the target position so that after initialization, laser pulses would be directed into the preformed cavities. The cavities provide a volume for the expansion of the target to occur.

## Claims

1. An X-ray irradiation system comprising an excitation beam (14) whose path is directed towards a target (18,50,64) and whose power is sufficient to cause an X-ray emitting plasma (20) to be created upon striking the target and means (36) to position an object to be irradiated within the region of emitted X-rays, characterised in that the target (18,50,64) has a cavity (40) therein, the target being so positioned that the path of the beam intersects the cavity, the plasma (20) being created at least partially therein and the object (30,34,32) to be irradiated being positioned within a region defined by a cone of a certain angle (42) to the path, the cone being such that the intensity of the X-rays within the region is greater than the intensity of the X-rays if the path of the beam intersected a non-cavity part of the target.

2. A system according to claim 1, in which the cavity is formed by the excitation beam being directed towards a non-cavity area of the target.

3. A system according to claim 1 or 2, in which the excitation beam is a pulsed laser beam.

4. A system according to claim 1, 2 or 3 in which the cavity has a smaller cross sectional area than the cross sectional area of the plasma created if the beam strikes a non-cavity area of the target.

5. A system according to claim 1, 2, 3 or 4, in which the cavity has cross sectional area larger than the cross sectional area of the beam at the spot where the beam strikes the cavity.

6. A system according to any preceding claim, in which the beam is directed towards the cavity a plurality of times.

7. A system according to claim 6, in which the cavity increases in depth each time the beam is directed towards the cavity.

8. A system according to claim 2, or any claim appendant to claim 2, in which the intensity of the X-rays emitted during the initial formation of the cavity is less than the intensity of the X-rays emitted thereafter, and means (72) is provided to prevent the X-rays emitted during formation of the cavity from striking the object.

9. A system according to any preceding claim in which the object is at least one desired area on a semi-conductor substrate.

10. A system according to any preceding claim including excitation beam generating means in the form of a high repetition rate, high power pulse laser generator (12), the beam being a high power short duration laser beam.

11. A system according to any preceding claim, in which the target is of metal.

12. A system according to any preceding claim in which the target is positioned within an evacuated chamber (24).

13. A system according to any preceding claim, in which the object positioning means comprises semiconductor wafer holding and moving means (36) for positioning selected areas of a semiconductor wafer in an exposing area, the exposing area being within the higher intensity X-ray region.

14. A system according to any preceding claim, in which the target is a strip (64) extending between a feed spool on a supply reel (66) and a receiving spool on a take-up reel (68), and longitudinally movable thereinto.

15. A system according to claim 14, in which the intersection of the beam with the strip is movable transversely of the longitudinal movement of the strip.

16. A system according to claim 14, in which the transverse movement of the intersection is effected by movement of the strip.

17. A system according to claim 14, 15 or 16 in which the supply reel (66), take-up reel (68) and strip (64) are within an enclosure forming a cassette (74).

## Patentansprüche

1. Eine Bestrahlungsvorrichtung mit Röntgenstrahlen, die einen Anregungsstrahl (14) umfaßt, dessen Bahn auf eine Fangelektrode (18, 50, 64) gerichtet ist und dessen Kraft ausreichend ist, ein Röntgenstrahlen emittierendes Plasma (20) beim Auftreffen auf die Fangelektrode zu verursachen und Vorrichtungen (36), um einen zu bestrahlenden Gegenstand im Bereich der emittierten Röntgenstrahlen zu positionieren, dadurch gekennzeichnet, daß die Fangelektrode (18, 50, 64) eine Vertiefung (40) hat und die Fangelektrode so positioniert wird, daß der Strahlengang sich mit der Vertiefung kreuzt, das Plasma (20) zumindest teilweise darin erzeugt wird, und der zu bestrahlende Gegenstand (30, 34, 32) innerhalb eines Bereiches positioniert wird, der durch den Kegel eines bestimmten Winkels (42) zum Strahlengang definiert ist, und der Kegel sich dadurch auszeichnet, daß die Intensität der Röntgenstrahlen innerhalb des Bereiches größer ist als die Intensität der Röntgenstrahlen, wenn der Strahlengang eine nicht vertiefte Fläche der Fangelektrode gekreuzt hat.

2. Vorrichtung gemäß Anspruch 1, bei der die Vertiefung durch einen Anregungsstrahl ausgebildet wird, der gegen eine nicht vertiefte Fläche der Fangelektrode gerichtet wird.

3. Vorrichtung gemäß den Ansprüchen 1 oder 2, bei der der Anregungsstrahl ein impulsartiger Laserstrahl ist.

4. Vorrichtung gemäß den Ansprüchen 1, 2 oder 3, bei der die Vertiefung eine Querschnittsfläche hat, die kleiner als die Querschnittsfläche des Plasmas ist, das gebildet wird, wenn der Strahl auf eine nicht vertiefte Fläche der Fangelektrode trifft.

5. Vorrichtung gemäß den Ansprüchen 1, 2, 3 oder 4, bei der die Vertiefung eine Querschnittsfläche hat, die größer als die Querschnittsfläche des Strahles an dem Punkt ist, wo der Strahl auf die Vertiefung trifft.

6. Vorrichtung gemäß einem der vorhergehenden Ansprüche, bei der der Strahl vielmals gegen die Vertiefung gerichtet wird.

7. Vorrichtung gemäß Anspruch 6, bei der die Vertiefung jedesmal an Tiefe zunimmt, wenn der Strahl auf die Vertiefung gerichtet wird.

8. Vorrichtung gemäß Anspruch 2 oder einem vom Anspruch 2 abhängigen Anspruch, bei der die Intensität der während der Initialbildung der Vertiefung ausgestrahlten Röntgenstrahlen geringer ist als die Intensität der danach ausgestrahlten Röntgenstrahlen, und es ist eine Vorrichtung (72) vorgesehen, um die während der Ausbildung der Vertiefung ausgestrahlten Röntgenstrahlen abzuhalten, auf den Gegenstannd zu treffen.

9. Vorrichtung gemäß einem der vorhergehenden Ansprüche, bei der der Gegenstand mindestens eine ausgewählte Fläche auf einem Halbleitersubstrat ist.

10. Vorrichtung gemäß einem der vorhergehenden Ansprüche, die Mittel zur Erzeugung von anregenden Strahlen in einer hohen Folgefrequenz, einen Hochleistungsimpulslasergenerator (12) und einen Strahl umfaßt, der ein Hochleistungskurzzeitlaserstrahl ist.

11. Vorrichtung gemäß irgendeinem der vorhergehenden Ansprüche, bei der die Fangelektrode aus Metall besteht.

12. Vorrichtung gemäß irgendeinem der vorhergehenden Ansprüche, bei der die Fangelektrode innerhalb einer Vakuumkammer (24) positioniert ist.

13. Vorrichtung gemäß irgendeinem der vorhergehenden Ansprüche, bei der die Vorrichtung zum Positionieren des Gegenstandes ein Halbleitermikroplättchen und Bewegungsvorrichtungen (36) enthält, um ausgewählte Flächen des Halbleitermikroplättchens in eine exponierte Fläche zu positionieren, wobei die exponierte Fläche innerhalb eines Bereiches höherer Röntgenstrahlungsintensität liegt.

14. Vorrichtung gemäß einem der vorhergehenden Ansprüche, bei der die Fangelektrode ein Streifen (64) ist, der sich zwischen einer Geberspule auf einer Versorgungsrolle (66) und einer Nehmerspule auf einer Aufnahmerolle (68) erstreckt und dort der Länge nach hineinbewegbar ist.

15. Vorrichtung gemäß Anspruch 14, bei der der Kreuzungsbereich des Strahles mit dem Streifen schräg zur Längsbewegung des Streifens bewegbar ist.

16. Vorrichtung gemäß Anspruch 14, bei der die schrägverlaufende Bewegung des Kreuzungsbereiches durch die Bewegung des Streifens verursacht wird.

17. Vorrichtung gemäß Anspruch 14, 15 oder 16, bei der die Versorgungsrolle (66), die Aufnahmerolle (68) und der Streifen (64) in einem Gehäuse sind, das eine Kassette (74) bildet.

## Revendications

1. Système d'irradiation par rayons X comprenant un faisceau d'excitation (14), dont la trajectoire est dirigée vers une cible (18, 50, 64) et dont la puissance est suffisante pour amener un plasma (20) émetteur de rayons X à être créé lors de l'impact sur la cible, et des moyens (36) pour positionner un objet à irradier à l'intérieur de la région des rayons X émis, caractérisé par le fait que, dans la cible (18, 50, 64), est pratiquée une cavité (40), la cible étant positionnée de sorte que la trajectoire du faisceau rencontre la cavité, le plasma (20) étant créé au moins partiellement dans celle-ci et l'objet (30, 34, 32) à irradier étant positionné à l'intérieur d'une région définie par un cône d'un certain angle (42) par rapport à la trajectoire, le cône étant tel que l'intensité des rayons X à l'intérieur de la région est supérieure à l'intensité des rayons X si la trajectoire du faisceau rencontrait une partie de non-cavité de la cible.

2. Système selon la revendication 1, dans lequel la cavité est formée par le faisceau d'excitation qui est dirigé vers une zone de non-cavité de la cible.

3. Système selon l'une des revendications 1 ou 2, dans lequel le faisceau d'excitation est un faisceau de laser pulsé.

4. Système selon l'une des revendications 1, 2 ou 3, dans lequel la cavité a une zone en coupe transversale plus petite que la zone en coupe transversale du plasma créé si le faisceau frappe une zone de non-cavité de la cible.

5. Système selon l'une des revendications 1, 2, 3 ou 4, dans lequel la cavité a une zone en coupe transversale plus grande que la zone en coupe transversale du faisceau au niveau du spot où le faisceau frappe la cavité.

6. Système selon l'une des revendications précédentes, dans lequel le faisceau est dirigé vers la cavité une pluralité de fois.

7. Système selon la revendication 6, dans lequel la cavité augmente de profondeur chaque fois que le faisceau est dirigé vers la cavité.

8. Système selon la revendication 2, ou selon n'importe quelle revendication rattachée à la revendication 2, dans lequel l'intensité des rayons X émis pendant la formation initiale de la cavité est inférieure à l'intensité des rayons X émis par la suite, et des moyens (72) sont prévus pour empêcher les rayons X émis pendant la formation de la cavité de heurter sur l'objet.

9. Système selon l'une quelconque des revendications précédentes, dans lequel l'objet est au moins une zone désirée sur un substrat semi-conducteur.

10. Système selon l'une quelconque des revendications précédentes, comprenant des moyens pour engendrer un faisceau d'excitation, se présentant sous la forme d'un générateur de laser pulsé (12) à fréquence de répétition élevée et de grande puissance, le faisceau étant un faisceau laser de courte durée et de grande puissance.

11. Système selon l'une quelconque des revendications précédentes, dans lequel la cible est en métal.

12. Système selon l'une quelconque des revendications précédentes, dans lequel la cible est positionnée à l'intérieur d'une chambre mise sous vide (24).

13. Système selon l'une quelconque des revendications précédentes, dans lequel les moyens de positionnement de l'objet comprennent des moyens (36) de fixation et de déplacement d'une plaque de semi-conducteur pour positionner des zones choisies d'une plaque de semi-conducteur dans une zone d'exposition, la zone d'exposition se trouvant à l'intérieur de la région des rayons X d'intensité supérieure.

14. Système selon l'une quelconque des revendications précédentes, dans lequel la cible est une bande (64) s'étendant entre une bobine débitrice sur un rouleau d'alimentation (66) et une bobine réceptrice sur un rouleau récepteur (68), et déplaçable longitudinalement au-dedans.

15. Système selon la revendication 14, dans lequel l'intersection de faisceau avec la bande est déplaçable transversalement par rapport au mouvement longitudinal de la bande.

16. Système selon la revendication 14, dans lequel le mouvement transversal de l'intersection est effectué par déplacement de la bande.

17. Système selon l'une des revendications 14, 15 ou 16 dans lequel le rouleau d'alimentation (66), le rouleau récepteur (68) et la bande (64) se trouvent à l'intérieur d'une enceinte formant une cassette (74).

Fig.1.

Fig.2A.   Fig.2B.   Fig.2C.   Fig.2D.

Fig.3.

Fig.4.